# EUROPEAN PATENT APPLICATION

(11) **EP 1 067 282 A2**
(43) Date of publication of application: **10.01.2001**
(21) Application number: 00120533.5
(22) Date of filing: 02.03.1994
(51) Int. Cl.: F02C 7/224, F02C 7/32, F02C 7/14, F01D 25/20

(54) **Integrated engine control system for a gas turbine engine**

(30) Priority: 03.03.1993 US 26455; 10.09.1993 US 119948
(62) Divisional of application: 94912173.5
(71) Applicant: KETEMA AEROSPACE & ELECTRONICS DIVISION, El Cajon, CA 92021 (US)
(72) Inventor: Simmons, Robert L, El Cajon, CA 92020 (US); Grulich, Frank B., Campo, CA 91906 (US); Telfer, Benedict R., San Diego, CA 92124 (US)
(74) Representative: Orr, William McLean

(57) **Abstract**

An engine control system and method for monitoring and controlling operation of a gas turbine engine. The system comprises a fuel metering device having a fuel pump, drive means for driving the fuel pump, a flow meter, and control means for utilizing a flow meter signal to control the speed of the drive means and pump. A tachometer may be utilized as a secondary feedback mechanism under certain predetermined operating conditions. Furthermore, a third feedback mechanism in the form of a metering valve and valve position sensor may be used to provide a triple-redundant feedback system. An oil metering device is utilized for monitoring and controlling the flow of oil in a gas turbine engine. The oil metering device includes an oil pump, drive means for driving the oil pump, and control means for controlling the speed of the drive means and pump. Similar to the fuel metering device, the oil metering device may comprise one or more of the noted feedback systems to control the oil flow rate. The electric fuel pump, electric oil pump, and control means are all collocated in one area of the engine, preferably the jet core housing.

## Description

### FIELD OF THE INVENTION

The present invention generally relates to gas turbine engines and, more particularly, to an electric control system which enhances one or more aspects of monitoring, controlling and maintaining the operation of fluid supply systems in gas turbine engines.

### BACKGROUND OF THE INVENTION

In the operation of gas turbine engines, it is important to have a reliable means for supplying fluids, such as fuel and oil, to certain components of the engine. For example, pressurized fuel must be supplied to the combustor of the engine and pressurized oil must be supplied to the engine bearings (e.g., the gear box and powerhead bearings). Typically, supply of fuel and oil to the engine is provided by gear driven pumps mounted on the fan housing in the nacelle of the engine. Such pumps are typically driven off of the main turbine shaft through inner and outer gear boxes and auxiliary drive shafts connecting the inner gear box at the turbine drive shaft to the outer gear box on the engine housing. As such, it can be appreciated that the fuel and oil pumps are directly mechanically connected to the turbine drive shaft and therefore rotate at a speed which is proportional to the speed of the turbine.

The speed of the turbine, and consequently the power output of the engine, is proportional to the amount of fuel entering in the combustor (i.e., the fuel flow rate) for a given set of operating conditions. Consequently, it is important to provide a means for accurately controlling the fuel flow rate. Typically, control of the fuel flow rate is accomplished through the use of a metering valve positioned downstream from the fuel pump whereby excess fuel (i.e., fuel which is pumped by the fuel pump but which is not required for operation of the engine) may be diverted back to the fuel line upstream of the fuel pump. The position of the metering valve determines the ratio of the amount of fuel which is diverted to the amount of fuel which is allowed to reach the combustor of the engine. In many gas turbine engine control systems, as much as 75% of the pumped fuel is diverted at rated speed. Such metering valves can either be mechanically or electrically controlled.

Since precise metering of oil flow rate is not required for normal operation of a gas turbine engine, it is generally thought unnecessary to provide a means for controlling the oil flow rate. Accordingly, prior art oil pumps in gas turbine engines typically pump at a rate which is proportional to the speed of the turbine, without the use of metering valves to bypass a portion of the oil.

Because the above-described mechanically-actuated fluid pumps require the use of multiple gear boxes and drive shafts, such mechanical systems tend to be bulky and, therefore, can have considerable weight and aerodynamic disadvantages. Furthermore, such mechanical systems can be unreliable (e.g., due to contamination, wear and corrosion), thereby requiring high maintenance and the provision of multiple backup systems. Additionally, due to the tolerances required fore proper operation of the mechanical components (e.g., the multiple gear boxes, drive shafts and metering valves), such mechanical components can be expensive to manufacture and difficult to service. Such mechanical systems also tend to be inefficient due to the waste of pumping energy by diverting a substantial portion (e.g., as much as 75%) of the fuel back to the fuel pump, thereby wasting energy and undesirably generating heat in the fluid.

Furthermore, positioning of the fuel and oil pumps in the nacelle requires that the nacelle be undesirably large, resulting in aerodynamic inefficiencies. Such positioning also results in high costs to replace the jet core, due to the fact that the fuel pump must be replaced with the jet core.

While certain aspects of fluid control in gas turbine engines have been converted from mechanical to electrical operation, substantial further improvements have been achieved and are disclosed hereinbelow.

### SUMMARY OF THE INVENTION

It is an object of the present invention to provide a fluid metering device and method for controlling fluid flow wherein the fluid flow rate is monitored and controlled utilizing an accurate feedback mechanism. It is a related object to provide a fluid metering device and method wherein one of two potential feedback mechanisms may be used, depending on a predetermined set of conditions. It is another related object to provide a third mechanism for providing feedback and controlling fluid flow in the event that the first two feedback mechanisms are defective.

It is another object of the present invention to provide a method whereby an electric fluid pump in an engine can be utilized to heat a fluid prior to starting the engine under cold conditions.

Still another object of the present invention is to provide an adaptive oil supply system for an engine whereby the temperature and flow rate of oil supplied to the engine bearings can be controlled based upon a predetermined set of conditions.

It is yet another object of the present invention to provide a serviceable, energy-efficient engine control system for monitoring and controlling the operation of fluid supply systems in gas turbine engines. It is a related object of the present invention to provide such a control system which is accurate, low in weight, relatively compact, and can operate in a high-temperature environment.

These objects are met by the utilization of electrically-operated components and control mechanisms which are combined to provide an integrated engine control (IEC) system particularly adapted to programmably control fluid flow in a gas turbine engine. The IEC system includes a plurality of operatively interconnected subsystems, each of which contributes in some respect to providing engine control to achieve one or more of the above-identified objectives.

In one aspect of the present invention, the IEC system may incorporate a fuel control and delivery subsystem having an engine fuel metering device which controllably supplies fuel to an engine. The fuel metering device includes a fuel pump for pumping fuel through a fuel line, drive means for driving the fuel pump, a flow meter for monitoring the actual fuel flow rate, and control means for receiving a flow meter signal and sending a variable output to the drive means for variably controlling the speed of the drive means. The flow meter signal can be compared to a pump command (e.g., a pre-programmed desired fuel flow rate or a fuel flow rate calculated from a set of operating parameters) and the resulting error between the pump command and the flow meter signal (i.e., the first error signal) can be used to correct the pump speed. The utilization of a flow meter signal as a feedback mechanism provides an accurate means for monitoring the fuel flow rate and, when combined-with a control means and a variable speed fuel pump, provides an accurate, on-demand fuel metering device which overcomes many of the deficiencies of prior art devices.

The fuel metering device may preferably incorporate a tachometer for monitoring the speed of the fuel pump and generating a tachometer signal. The control means can receive the tachometer signal and utilize the tachometer signal as the feedback mechanism instead of the flow meter signal. That is, the control means can compare the tachometer signal to the pump command to calculate a second error signal which can be utilized to modify the pump speed under a predetermined set of conditions. For example, since the speed of the pump will generally be a more accurate representation of the fuel flow rate when there is a changing pump speed (i.e., when the first error signal exceeds a certain value), the tachometer signal may be used as the feedback mechanism whenever the first error signal exceeds a predetermined value. Correspondingly, the flow meter signal can be used when the first error signal is at or below the predetermined value. In addition, the tachometer signal can be used as the feedback mechanism if the flow meter signal is defective, and vice versa. The embodiment just described provides a dual-redundant fuel metering device and method whereby the accuracy of the feedback mechanism is improved by changing the feedback mechanism depending on the dynamic state of the device.

The fuel metering device may further comprise a metering valve positioned adjacent the fuel line for selectably controlling the fuel flow rate through the fuel line. A valve position sensor may further be provided for sensing the position of the metering valve and generating a valve position signal proportional thereto. Such valve position signal may be received by the control means and may be used as the feedback mechanism for controlling the fuel flow rate under a predetermined set of conditions (e.g., if it is determined that the flow meter and tachometer signals are defective). In such a situation, the control means will command the drive means to a constant speed and will control the fuel flow rate by controlling the position of the metering valve. Accordingly, such an embodiment provides a fuel metering device and method having a triple-redundant feedback mechanism.

The fuel metering device may further comprise an engine sensor input means for receiving an engine sensor signal from an engine sensor. The control means can be programmed to receive the engine sensor and flow meter signals and generate a variable output which is dependent on the incoming signals.

In another aspect of the invention, a method is provided for heating a fluid (e.g., fuel or oil) in an engine having a fluid pump driven by an electric motor. The method includes the steps of sending an illegal commutation command from a control unit to the electric motor to stall the motor and thereby generate heat, and dissipating the heat to the fluid. The dissipating step may be accomplished by positioning the motor in heat sink relationship with the fluid. The method may further include the step of sending a legal commutation command to the electric motor to rotate the motor and fluid pump to pump at least a portion of the fluid. Preferably, the steps of sending an illegal command, dissipating heat, and sending a legal command are sequentially performed to heat a substantial portion of the fluid in the engine prior to starting under cold conditions. The above-described method for heating fluid can facilitate starting a gas turbine engine in cold environments and can further reduce damage to certain components of the fluid delivery subsystems.

In yet another aspect of the invention, the IEC system includes an adaptive oil control and delivery subsystem for pumping oil in a gas turbine engine. The adaptive oil subsystem includes an oil pump for pumping oil through an oil line to a gas turbine engine, drive means for driving the oil pump, and control means for sending a variable output to the drive means for variably controlling the speed of the drive means. The system is termed "adaptive" because of its ability to change various characteristics of the oil flow (e.g., the flow rate and the temperature) in response to changing conditions. For example, the adaptive system may include an engine sensor for sensing an engine parameter (e.g., oil temperature, oil pressure, bearing temperature, exhaust gas temperature, etc.) and generating an engine signal proportional thereto. The control means can be designed to receive the engine signal and modify the oil flow characteristics to accommodate changes in the engine parameter (e.g., by increasing or decreasing the oil flow rate by increasing or decreasing the pump speed).

Similar to the fuel subsystem, the feedback mechanism for controlling the speed of the drive means can comprise a flow meter, a tachometer, a metering valve position sensor, or any combination of the three. The use of all three provides a triple-redundant device for controlling the oil flow rate in a gas turbine engine.

An oil cooling valve may be provided for controlling the amount of oil which is diverted to an oil cooling means (e.g., a fuel-cooled oil cooler). The cooling valve can be operatively connected to the control means and the position of the valve can be selectively monitored and controlled by the control means to regulate the amount of oil being diverted to the oil cooler (and thereby regulate the oil temperature). Such control of the oil cooling valve can be base upon operating characteristics of the engine (e.g., oil temperature, bearing temperature, exhaust gas temperature, etc.). Thus, the oil control and delivery subsystem of the present invention is capable of monitoring and controlling several aspects of the oil supply in a gas turbine engine and thereby provides an oil system which can adapt to changing operating conditions.

Still another aspect of the present invention is the combination of the above-described fuel subsystem, oil subsystem, and control means into an engine control system. The engine control system generally comprises a variable speed electric fuel pump, a variable speed electric oil pump, and control means for generating a fuel control voltage for controlling the speed of the fuel pump and an oil control voltage for controlling the speed of the oil pump. The engine control system may further comprise input means for receiving input signals which may affect the fuel control voltage or the oil control voltage. Such input signals preferably correspond to engine parameters, such as engine inlet pressure, engine inlet temperature, engine speed, ambient pressure, exhaust gas temperature, fuel temperature, fuel pressure, oil temperature, oil pressure, interstage temperatures, interstage pressures, speeds, or any other desired parameter. Output means may further be used for providing monitoring signals corresponding to a control system parameter (e.g., fuel pump current, oil pump current, fuel pump speed, oil pump speed, fuel flow rate, oil flow rate, etc.). Another aspect of the present invention involves the provision of a gas turbine engine having an IEC system which is collocated in one area of the engine. The IEC system generally includes an electric fuel pump, an electric oil pump, and control means for generating a fuel control voltage for controlling the fuel pump and an oil control voltage for controlling the oil pump. Collocation of the IEC system is preferably on the jet core housing, which provides several distinct advantages. First, for maintenance and repair, the system is easily accessible by a single individual at a single location, thereby decreasing maintenance time and associated costs. Second, removal of the fuel and oil pumps from the nacelle allows the nacelle to be made smaller, resulting in a decrease in drag coefficient and an associated decrease in specific fuel consumption. Furthermore, by moving the fuel pump from the fan housing to the jet core housing, the fan section (i.e., fan blades, fan body and fan housing) does not need to be removed when removing the engine.

### BRIEF DESCRIPTION OF THE DRAWINGS

Fig. 1 is a longitudinal section view of a prior art gas turbine engine;
Fig. 2 is a longitudinal section view of a gas turbine engine embodying the present invention;
Fig. 3 is a system diagram of the integrated engine control system of the present invention;
Fig. 4 is a plan view of a fuel metering device embodying the present invention;
Fig. 5 is a section view of a fuel pump and motor taken along line 5-5 in Fig. 4;
Fig. 6 is an exploded assembly view of the fuel pump shown in Fig. 5;
Fig. 7 is a schematic of the fuel control and delivery subsystem of the present invention;
Fig. 8 is a schematic of the fuel control electronics of the present invention;
Fig. 9 is a process flow diagram representing the determination of the proper feedback mechanism for fuel control; and
Fig. 10 is a schematic of the oil control and delivery subsystem of the present invention.

### DETAILED DESCRIPTION

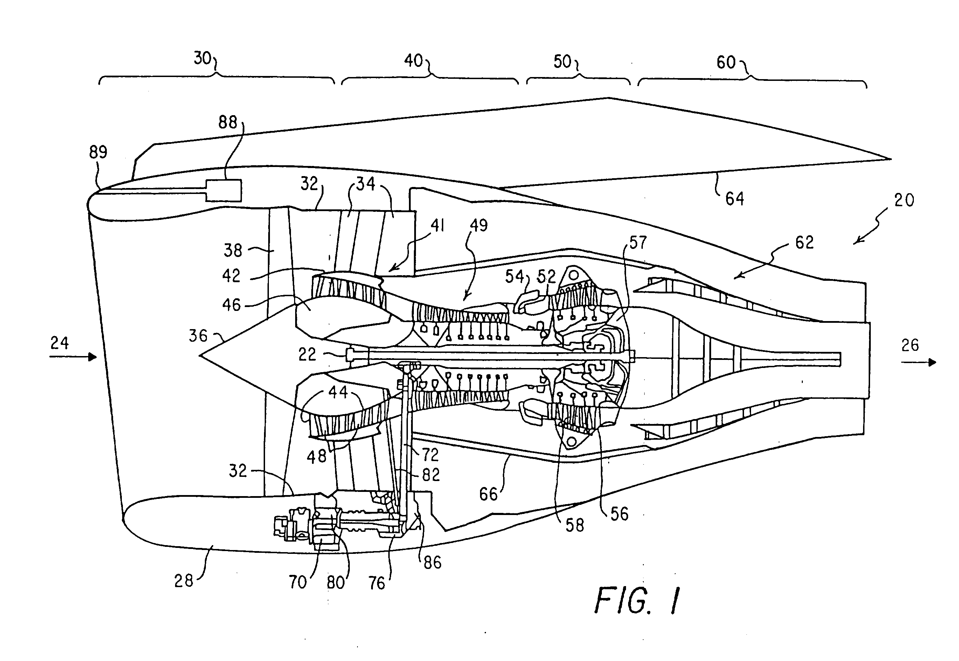

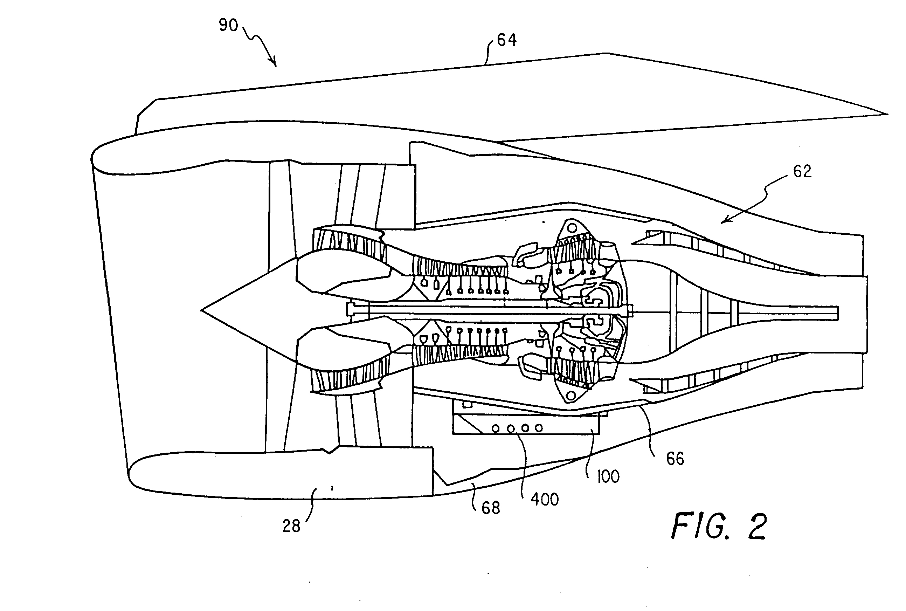

Figure 1 illustrates a cross section of a prior art gas turbine engine 20 which could be used as, for example, a thrust engine for a jet aircraft. More specifically, the engine depicted in Figs. 1 and 2 is a CFM56-5B engine manufactured by CFM International. The engine 20 generally comprises four sections: a fan section 30, a compressor section 40, a turbine section 50 and an exhaust section 60. The compressor section 40, turbine section 50 and exhaust section 60 collectively comprise the jet core 62, which is cantilevered from radial struts 34 which are structurally integrated with a pylon assembly 64 through a fan housing 32. The pylon assembly 64 provides for attachment of the engine 20 to the wing of an aircraft (not shown). The jet core 62 further comprises a jet core housing 66 for directing air flow in the engine 20.

The fan section 30 generally comprises a rotating fan body 36 having a plurality of rotational fan blades 38 extending radially outwardly therefrom. The fan housing 32 defines a cylindrical air tunnel through which the fan blades 38 push air. The fan body 36 is operatively connected to the turbine shaft 22 such that rotation of the turbine shaft 22 provides rotation to the fan body 36 and fan blades 38. Such rotation of the fan blades 38 forces air from the inlet 24 of the engine 20 to the outlet 26 to provide a thrust force to the aircraft.

The compressor section 40 comprises first-stage 41 and second-stage 49 compressors. The first-stage compressor 41 is positioned adjacent the fan section 30 and generally comprises a compressor housing 42 mounted to the inside ends of the radial struts 34, and a plurality of nonrotating stator blades 44 extending radially between the compressor housing 42 and the compressor body 46. The stator blades 44 provide support to a rotating compressor body 46 having a plurality of rotor blades 48 extending radially outwardly therefrom. Multiple rows of rotor blades 48 are positioned between multiple rows of stator blades 44 and are mounted for rotational movement relative to the stator blades 44 and compressor housing 42. The compressor body 46 is operatively connected to the turbine shaft 22 such that rotation of the turbine shaft 22 causes rotational movement of the compressor body 46 and rotor blades 48. The first-stage compressor 41 receives partially-compressed air from the fan section 30 and further compresses the air to provide compressed air to the second-stage compressor 49. The second-stage compressor 49 further compresses the air in a similar fashion to that of the first-stage compressor 41 and supplies the highly-compressed air to the combustor 54 in the turbine section 50.

The turbine section 50 is positioned adjacent the compressor section 40 and generally comprises a turbine housing 52 interconnected with the compressor housing 42 and a combustor 54 mounted to the turbine housing 52. Multiple rows of rotating turbine blades 58 are positioned between multiple rows of stationary turbine blades 56 and are mounted for rotational movement relative to the stationary blades 56 and turbine housing 52. The turbine body 57 is operatively connected to the turbine shaft 22 such that when the combustor 54 burns fuel and provides accelerated gases to the rotating turbine blades 58, the rotating blades 58 will rotate, thus causing rotation of the turbine shaft 22 and providing the required energy to the fan section 30 and the compressor section 40.

Delivery of fuel and oil to the engine 20 is provided by a fuel pump 70 and an oil pump 80 mounted on the fan housing 32 in the nacelle 28 of the engine 20. As seen in Fig. 1, the nacelle is larger at the bottom of the engine 20 (i.e., compared to the top of the engine 20) to accommodate the fuel and oil pumps 70,80 and associated gear boxes 76,86. Such pumps are powered by drive shafts 72,82 connected on one end to the turbine shaft 22 through turbine gear boxes (not shown) and connected on the other end to the respective pumps 70, 80 through pump gear boxes 76,86. Since the pumps 70, 80 are directly mechanically connected to the turbine shaft 22, the fuel pump 70 and the oil pump 80 will rotate at a speed proportional to the rotational speed of the turbine shaft 22. Typically, such drive shafts 72,82 pass radially outwardly from the turbine gear boxes to the pump gear boxes 76,86 through one of the radial struts 34.

Fuel control is typically provided through the use of a metering valve (not shown in Figs. 1 and 2) located in the fuel line (not shown in Figs. 1 and 2) downstream of the fuel pump 70. The metering valve is integrally connected with a fuel diversion line (not shown in Figs. 1 and 2) that diverts unneeded fuel from the metering valve back to the fuel line upstream of the fuel pump 70. The position of the metering valve determines the amount of fuel that is diverted back and, accordingly, determines the amount of fuel sent to the combustor 54.

A similar metering valve can be used to control the oil flow through the engine 20. However, the oil flow in gas turbine engines is typically not controlled and, therefore, the oil flow rate will typically only vary as the rotational speed of the turbine shaft 22 varies.

Control of the metering valve can be provided by an electronic control unit 88 ("ECU") which is operatively connected to the metering valve. Because of the high temperatures of the engine 20 and the temperature sensitivity of the ECU 88, the ECU 88 must be located away from the engine 20. Accordingly, the ECU 88 is positioned in the nacelle 28 of the engine 20 and is air cooled through a cooling port 89.

Referring now to Fig. 2, there is shown a section view of a gas turbine engine 90 embodying the features of the present invention. As with the prior art engine 20 shown in Fig. 1, the engine depicted in Fig. 2 is a CFM56-5B engine, with the exceptions noted herein.

The engine 90 of the present invention comprises an integrated engine control ("IEC") system 100 whereby various aspects of the engine operation are monitored and controlled through various subsystems, all of which are positioned in one serviceable location on the engine 90. The IEC system 100 replaces the ECU, gear-driven fuel and oil pumps, and corresponding gear boxes and drive shafts of the previously-described prior art gas turbine engine 20. The IEC system 100 can be positioned at any location on the aircraft, but is preferably positioned where it is easily accessible to ground personnel for maintenance and repair. More preferably, as shown in Fig. 2, the IEC is secured to the jet core housing 66, where it is easily accessible via, for example, a service hatch (not shown) or through the thrust reverser 68 or by opening the nacelle 28 by standard procedures. Such location on the jet core housing 66 decreases the length of fuel lines, oil lines, and any required wiring harnesses for communication with the jet core 62. Alternatively, the IEC system 100 could be located in the nacelle 28, in the pylon assembly 64, in the wing (not shown) or other part of the aircraft. However, it is believed that location on the jet core housing 66 provides the greatest advantages as noted above and as further noted herein.

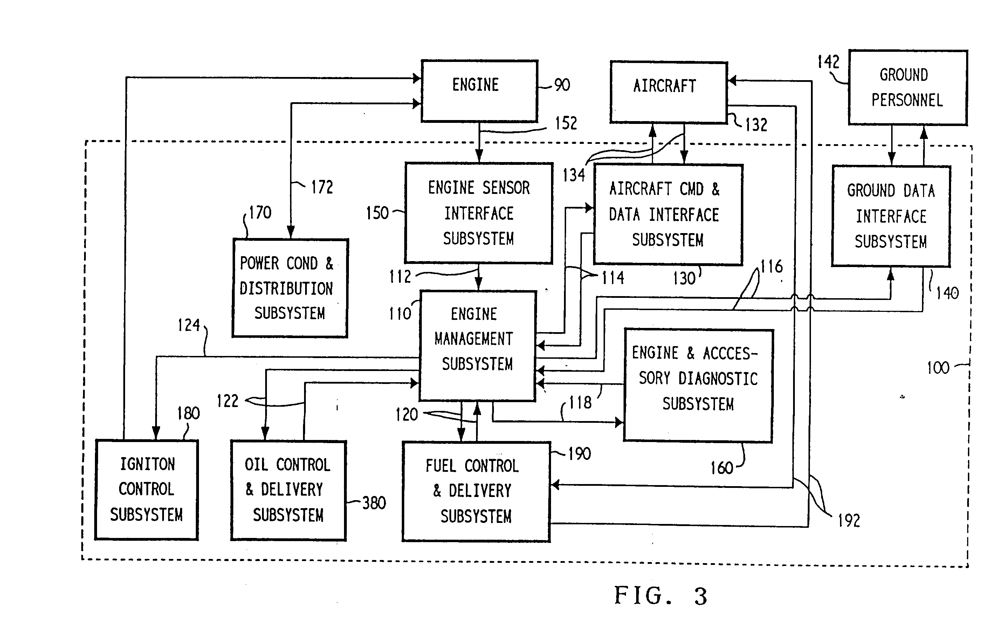

Referring to the system diagram of Fig. 3, the subsystems of the IEC system 100 include an engine management subsystem 110, an aircraft command and data interface subsystem 130, a ground data interface subsystem 140, an engine sensor interface subsystem 150, an engine and accessory diagnostic subsystem 160, a power conditioning and distribution subsystem 170, an ignition control subsystem 180, a fuel control and delivery subsystem 190, and an oil control and delivery subsystem 380. Each of the subsystems performs a specific function in the control and management of the gas turbine engine 20, as will be described herein in more detail.

Each of the above-referenced subsystems is preferably separately replaceable from the rest of the system. That is, if a subsystem fails, the subsystem can be removed and replaced without the need to also remove and replace part or all of the IEC system 100. Accordingly, each subsystem is referred to as a line replaceable unit. Such separate replaceability provides advantages in the repair and maintenance of the system.

The operation of each subsystem will now be described with reference to the system diagram shown in Fig. 3. The engine management subsystem 110 comprises a processing unit for coordinating and supervising all IEC subsystems. For example, the engine management subsystem 110 monitors electronics thermal management, controls engine actuators, analyzes test data and diagnostics, maintains engine historical and maintenance data, conducts IEC to aircraft-communications, and conducts IEC to ground communications. In essence, the engine management subsystem 110 acts as the brains of the IEC system 100. Preferably, the engine management subsystem 110 is reprogrammable such that the engine management subsystem 110 can be customized to achieve the desired performance characteristics for different applications (e.g., different fuels, engines and aircraft).

As can be seen in Fig. 3, the engine management subsystem 110 communicates with most of the other subsystems through various communication links. For example, the engine management subsystem 110 can receive an engine sensor signal from the engine sensor interface subsystem 150 through a communication link 112 and can be programmed to provide that signal to a desired subsystem (e.g., to the fuel control and delivery subsystem 190, to the engine and accessory diagnostic system 160, or to the aircraft command and data interface subsystem 130). Furthermore, the engine management subsystem 110 can send and receive signals to and from the aircraft command and data interface subsystem 130 (through one set of communication links 114), the ground data interface subsystem 140 (through another set of communication links 116), the engine and accessory diagnostic subsystem 160 (through communication links 118), the fuel control and delivery subsystem 190 (through communication links 120), and the oil control and delivery subsystem 380 (through communication links 122). The engine management subsystem 110 can further provide an output signal through a communication link 124 to the ignition control subsystem 180 for proper ignition of the engine 90 under varying operating conditions.

The aircraft command and data interface subsystem 130 provides electronic interfaces between the aircraft 132 and the engine management subsystem 110 for command and data transfers. For example, commands such as increase or decrease thrust will be sent from the aircraft 132 through a communication link 134 to the aircraft command and data interface subsystem 130 and through another communication link 114 to the engine management subsystem 110 for appropriate action. In addition, engine data such as subsystem health and component diagnostics can be transferred from the engine management subsystem 110 to the aircraft command and data interface subsystem 130 and ultimately to the aircraft 132 to keep the aircraft 132 apprised of the overall IEC system health (e.g. through cockpit displays, emergency indication lights, etc.).

The ground data interface subsystem 140 provides electronic interfaces for command and data transfer to and from ground personnel 142. For example, historical data relating to engine performance can be downloaded by the ground personnel 142 from the IEC. Furthermore, the ground personnel can perform built-in tests on individual subsystems of the IEC to ensure proper operational capacity before aircraft take-off. In addition, the ground personnel can download the existing software programs and upload new or revised programs to alter the performance characteristics of gas turbine engine.

The engine sensor interface subsystem 150 filters, conditions, scales and converts all engine sensor data so that it may be understood by the various subsystems to which the signals are sent. For example, the engine sensor interface subsystem 150 may be used to filter background interference to provide a clear sensor signal. Furthermore, the subsystem may be used to provide analog to digital conversion of incoming sensor signals, such as exhaust gas temperature, air inlet pressure, engine speed, air temperature, interstage temperatures, interstage pressures, speeds, or any other desired parameter. Preferably, the engine sensor interface subsystem 150 is reconfigurable so it can condition whatever sensory information is desired for any particular application. In short, any engine sensor signals that require conditioning of any kind will pass from the engine 90 through a communication link 152 to the engine sensor interface subsystem 150 before passing through another communication link 112 to the engine management subsystem 110 for further processing and distribution.

The engine and accessory diagnostic subsystem 160 provides real-time monitoring of the status and health of the engine 90 and the IEC subsystems. For example, the engine and accessory diagnostic subsystem 160 can monitor certain engine sensor signals, through a communication link 118 with the engine management subsystem 110, which are indicative of certain parameters of the engine 90. Parameters which may provide information relating to the health of the engine 90 include the exhaust gas temperature, the engine speed and interstage temperatures and pressures. Similarly, the engine and accessory diagnostic subsystem 160 can monitor certain accessory (e.g. subsystem) signals which are indicative of subsystem health, such as the fuel motor current, the oil motor current, the fuel pump and oil pump speeds, the fuel flow rate, the oil flow rate, the fuel and oil pressures, and the fuel and oil temperatures. Each of these parameters can be monitored and the signals can be stored as information in the engine management subsystem 110, sent through the engine management subsystem 110 to the aircraft 132 as an indication signal (e.g., emergency indication light), used to override the system to maintain the engine health or prevent engine failure, or used for any other desired function that may be desired for a particular application.

The power conditioning and distribution subsystem 170 is provided for regulating the power entering the IEC system 100. It should be noted that full power for the electric pump motors is not required during all phases of engine operation. Peak powers are only needed for the motors during normal operation at rated speed. During the start phase or initial cranking of the engine 90, low power is required. Accordingly the 28 volt d/c aircraft battery (not shown) could be used during the start phase. Similarly, during the initial ignition phase, the power requirements are still low enough to use the aircraft battery. However, during the normal operation phase, there is a much higher power requirement than the first two phases. During normal operation, as much as about 150 amps at 270 volts d/c may be required to run a CFM56-5B engine. In order to obtain this power, a redesign of the starter motor (not shown) as a starter/generator may be required. The power conditioning and distribution subsystem 170 is provided to receive battery and generator power through a power link 172, and condition and distribute both the battery and generator power for the IEC system 100.

The ignition control subsystem 180 is a standard solid state, high-energy, spark-type ignition system. Such systems are standard in the industry and an appropriate system could be obtained from industry suppliers.

Mechanically-driven fuel systems are designed to meet the low speed start fuel flow requirements, which are much higher as a function of pump speed than the rated speed requirements. That is, the ratio of required fuel flow to engine speed is much higher at low speeds than at rated speed. As a result, such mechanically-driven fuel systems pump as much as four times the peak engine fuel flow at rated speed, only to divert the excess flow. Such excess speed and diverted fuel can undesirably generate heat in the fuel, such that the fuel is less suitable for use as a coolant (e.g., for cooling electronics, oil, etc.). Furthermore, such excess capacity means that the pumps are much larger than needed, resulting in significant space and weight penalties.

In contrast, the fuel control and delivery subsystem 190 of the disclosed embodiment is an on-demand, electronic fuel system which delivers only the required amount of fuel for the proper operation of the engine 90. More specifically, instead of diverting as much as 75% of the fuel to obtain the desired fuel flow rate, the fuel control and delivery subsystem 190 of the disclosed embodiment controls the speed of the fuel pump 200 to achieve the desired fuel flow rate. In this regard, the fuel control and delivery subsystem 190 receive signals through a communication link 120 from the engine management subsystem 110. Such signals provide information relating to or affecting the desired fuel flow rate (e.g., throttle position signal received from the aircraft, exhaust gas temperature, engine speed, as well as other signals). The fuel control and delivery subsystem 190 receives the signals and correspondingly modifies the fuel pump speed to achieve the desired fuel flow rate. The fuel control and delivery subsystem 190 can further provide signals relating to the operation of the fuel pump 200 and motor directly to the aircraft 132 through communication links 192 for indication and/or diagnostic purposes. Furthermore, the fuel control and delivery subsystem 190 is capable of direct control by, and communication with, the aircraft through communication links 192 under certain conditions (e.g., for emergency fuel shut off).

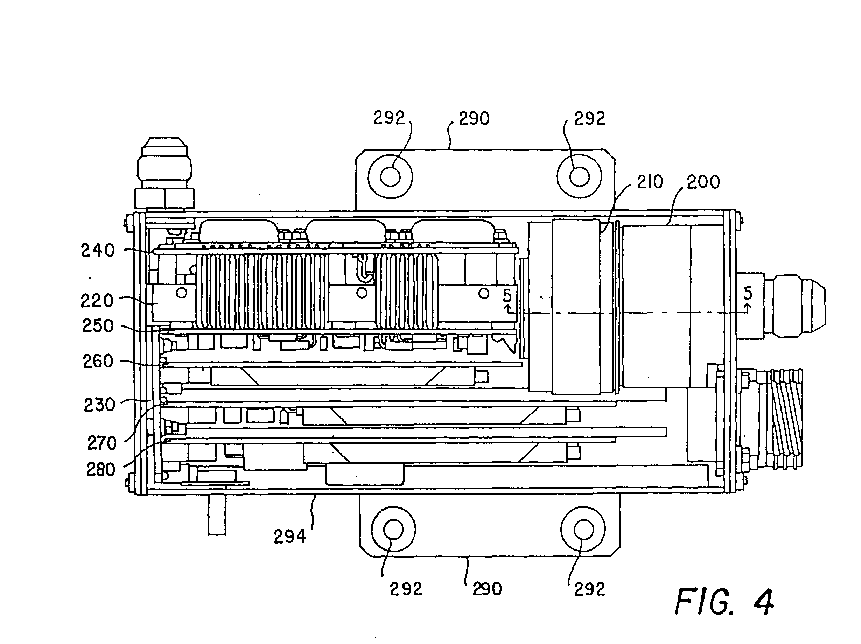

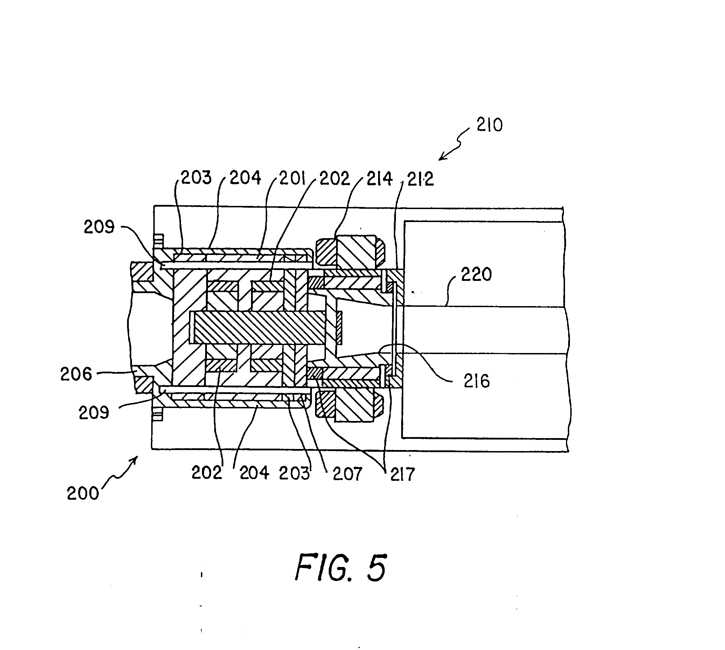

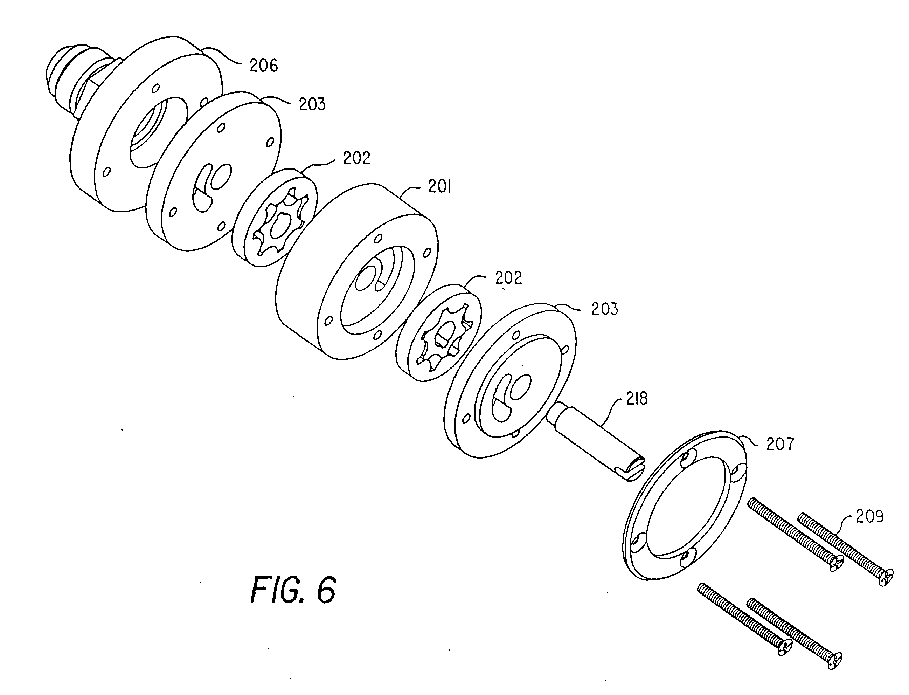

Referring now to Figs. 4-6, the fuel delivery subsystem 190 generally comprises a fuel pump 200, a motor 210 and drive electronics. The pump 200 utilizes two gerotors 202 in series and can be of the type available from Eaton Corporation under the name or mark "GEROTOR," but other suitable pumps can be obtained from other pump manufacturers. Using such a two-stage pump decreases the delta pressure across each stage by one-half and, accordingly, decreases wear and increases reliability. It should be appreciated that pumps utilizing a different number of stages could also be utilized, depending on the desired performance characteristics. The gerotors 202 are manufactured from stainless steel and are broached and ground into matched sets. The gerotors 202 are positioned in a dual-sided, carbon graphite cup 201 to which is secured carbon graphite wear plates 203 on both ends. The carbon graphite wear surfaces of the pump have exceptional wear characteristics and have demonstrated high tolerance to contamination. The carbon graphite is especially formulated for use with light lubricant fluid and kerosene-based fuels. The cup 201, gerotors 202, and wear plates 203 are sandwiched between a stainless steel inlet port plate 206 and a stainless steel support plate 207, all of which are held together by securing means, such as four screws 209. The pump 200 is housed within a stainless steel housing 204, which is sealingly connected to the inlet port plate 206 (e.g., by welding or the like) on one end and is sealingly connected (e.g., by welding or the like) to the end cap 212 of the adjacent motor 210 on the other end. Such end cap 212 is further sealingly connected (e.g., by welding or the like) to a fuel tube 220. A similar pump, except having a single stage, is disclosed in U.S. Patent No. 5,092,748 to Simmons, II, issued March 3, 1992.

The motor 210 is a d/c brushless motor having an external stator 214 on the outside of the housing 204 and a tubular rotor 216 positioned inside the housing 204. The stator 214 is completely isolated from the fuel, but is thermally stabilized by the fuel due to heat sinking from the stator 214 to the fuel (e.g., through the housing 204). The rotor 216 includes integral carbon graphite sleeve bearings 217 which offer good lubricity and wear characteristics in addition to size and weight advantages. The rotor 216 is drivingly coupled by means of a drive shaft 218 to the pump 200. The rotor 216 utilizes rare earth magnets, such as samarium cobalt magnets, but could alternatively use other rare earth magnets such as neodymium iron boron magnets. Commutation sensing for the motor 210 is accomplished by Hall Effects devices (not shown), which are located at 30 degree intervals around the perimeter of the motor 210 and sense the magnetic field of a trigger magnet located at the end of the rotor 216. It should be appreciated that other methods of sensing commutation can be used, such as by back EMF, the use of a resolver, or the use of an encoder.

Referring specifically to Fig. 4, the drive electronics of the fuel delivery subsystem 190 are mounted in a compact fashion within a housing 294, and include a vertically-oriented mother board 230 operatively connected to five horizontally-oriented circuit boards. The circuit boards include a motor drive board 240 positioned adjacent the fuel tube 220 such that the fuel flowing through the fuel line acts as a heat sink for cooling the power transistors 222 mounted on the motor drive board 240. A motor drive controller board 250 is mounted adjacent to and below the fuel tube 220. A central processing unit ("CPU") board 260 is positioned below the motor drive controller board 250. An analog interface board 270 may be provided for signal conditioning of engine sensor signals in the event that a separate engine sensor interface subsystem 150 is not used. A power/EMI board 280 is positioned below the analog interface board 270 (if an analog interface board 270 is used). Mounting flanges 290 and mounting holes 292 therethrough are interconnected with the housing 294 for mounting to an appropriate support.

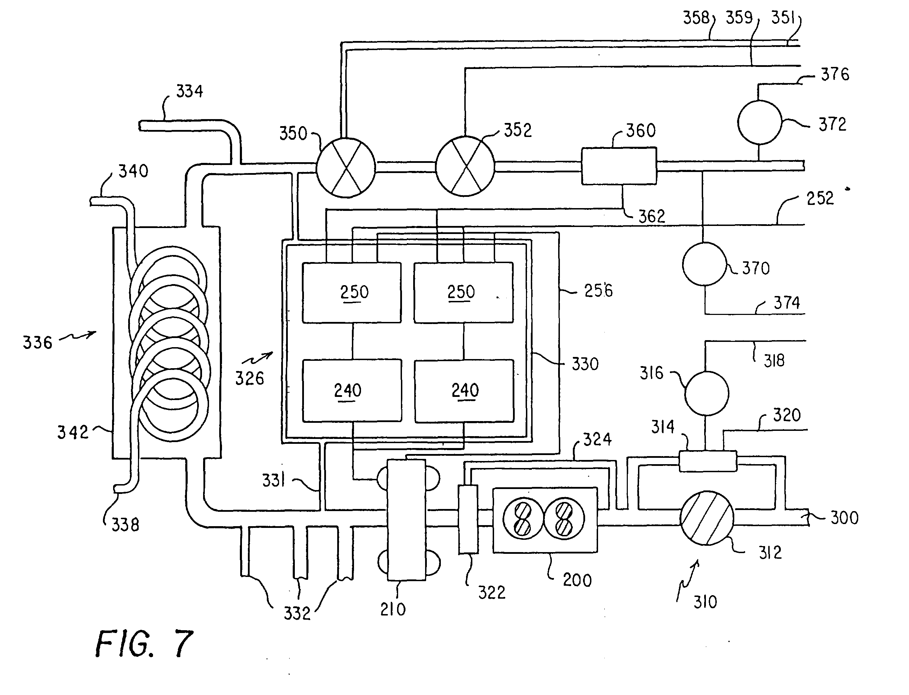

Fig. 7 is a schematic of the fuel control and delivery subsystem 190 and shows other pertinent components thereof. For example, adjacent the fuel inlet 300, a fuel filter and bypass assembly 310 is provided for filtering the fuel. The assembly 310 generally comprises a fuel filter 312 for filtering impurities from the fuel, and a filter bypass valve 314 for bypassing fuel around the filter 312 in the event that the filter 312 becomes blocked, For determining whether the fuel filter 312 is blocked, a pressure sensor 316 is provided for measuring the pressure across the fuel filter 312. A pressure sensor signal can be sent via a communication link 318 to the drive electronics of the fuel control and delivery subsystem 190 (e.g., the CPU board 260) for monitoring of the pressure differential. If the pressure differential exceeds a predetermined value, the drive electronics (e.g., the CPU board 260) can send a bypass control signal via a communication link 320 to the bypass valve 314 to allow the fuel to bypass the fuel filter 312.

The two-stage gerotor pump 200 is shown with a pressure relief valve 322 and fuel diversion line 324. Such pressure relief valve 322 will allow fuel to be diverted back upstream of the pump 200 if the pressure ratio across the pump 200 exceeds a predetermined value, thereby reducing the likelihood the pump 200 will be damaged due to high pressure differentials. Of course, in order to ensure accurate fuel metering, such a pressure relief valve 322 would only divert fuel in extreme situations and not under normal operating conditions.

The motor 210 is shown operatively connected to a dual redundant motor drive and controller assembly 326. That is, the motor controller board 250 and motor drive board 240 are duplicated in side-by-side parallel circuits to provide backup control in the event one of the circuits should fail. Operation of the motor drive and controller boards is described below in more detail in the discussion of the control electronics.

With the IEC mounted directly on the jet core housing 66, it is important to prevent over-heating of drive electronics (e.g., the motor drive and controller assembly 326). In this regard, an electronics cold plate 330 is supplied with fuel through a fuel diversion line 331 for cooling the motor drive and controller assembly 326. The use of an on-demand fuel pump is especially beneficial to the cold plate 330 because the fuel is generally cooler than fuel pumped by a prior art metering valve arrangement. That is, less heat is generated in an on-demand system than, for example, is generated in a prior art metering valve arrangement where as much as 75% of the fuel is diverted upstream of the pump and re-pumped. Fuel outlets 332 can further be provided for fuel-dependent operations (e.g., actuator control, motive flow or further electronics cold plate supply). A fuel inlet 334 provides a return for such fuel-dependent operations.

A fuel-cooled oil cooler 336 is provided for cooling the oil. Oil is supplied through an oil inlet 338, transported through a heat exchanger 342, and subsequently discharged through an oil outlet 340. As noted above with regard to the electronics cold plate 330, the use of an on-demand fuel pump is especially beneficial to the oil cooler 336 because the fuel is generally cooler than fuel pumped by a prior art metering valve arrangement. That is, less heat is generated in an on-demand system than, for example, is generated in a prior art metering valve arrangement where as much as 75% of the fuel is diverted upstream of the pump and re-pumped. Accordingly, the fuel should be better suited for cooling the oil.

A primary fuel shutoff and backup metering valve 350 is operatively connected to the control electronics (e.g., with the CPU board 260 through communication links 351 and 358) and serves two functions. First, the valve 350 can act as an emergency fuel shutoff valve for cutting fuel flow under emergency situations (e.g., in engine overspeed, fire shutdown or engine mechanical failure situations). Second, the valve 350 can act as a backup metering valve for metering the fuel flow in the event of a failure of the fuel metering feedback system, as described below in more detail. Such control of the valve 350 as a metering valve can be provided by the CPU board 260 through a communication link 351. Feedback of the valve position is provided from a position-sensing transducer (not shown) through a communication link 358. A secondary fuel shutoff valve 352 is connected to the control electronics (e.g., the CPU board) through a communication link 359 and is provided as a backup to the primary fuel shutoff valve 350.

A flow meter 360 is provided for measuring the actual fuel flow rate and for providing a signal proportional thereto through a communication link 362 to the motor controller board 250. The flow meter 360 is preferably an integral turbine-type paddle wheel flow meter with flow straighteners used in conjunction with a pickup coil to provide a flow meter signal to the motor controller. Alternatively, the flow meter 360 could comprise differential pressure, positive displacement, ultrasonic, or fluidic flowmeters. The flow meter 360 is preferably positioned within the fuel delivery subsystem 190 adjacent the motor drive controller, but could be positioned at other locations in the fuel line (e.g., immediately before the combustor 54). The fuel pressure sensor 370 and fuel temperature sensor 372 provide signals to the control electronics via communication links 374,376 for fuel metering and/or diagnostic purposes.

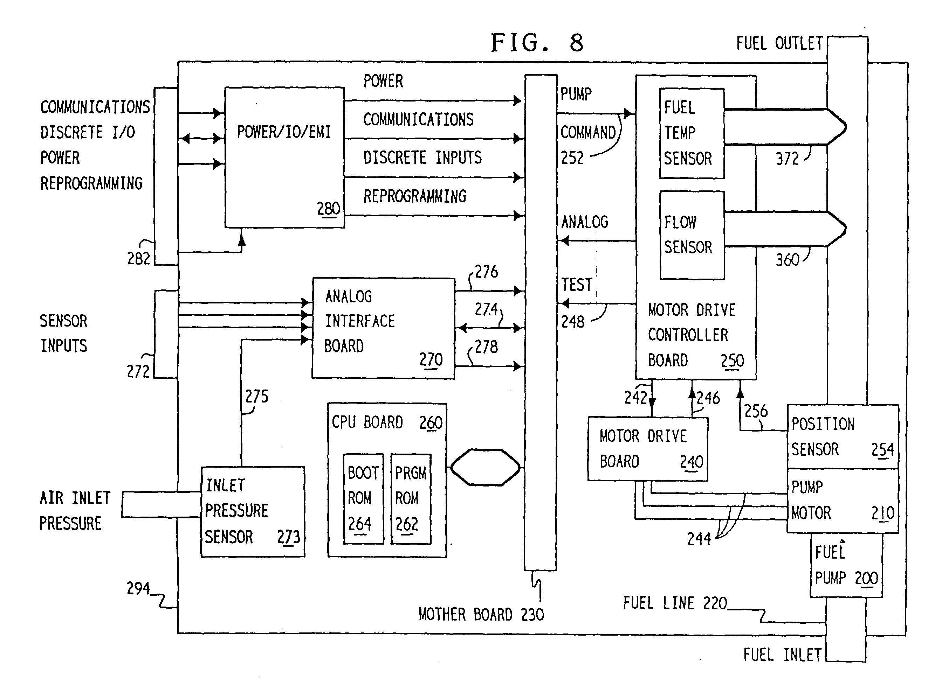

Referring to Fig. 8, a schematic of the control electronics of the fuel control and delivery subsystem 190 is shown. As noted above, the control electronics include a motor drive board 240, a motor controller board 250, a mother board 230, a CPU board 260, and a power/EMI board 280. An analog interface board 270 may further be provided for signal conditioning of engine sensor signals to be used for engine control in the event that a separate engine sensor interface subsystem 150 is not used. That is, the conditioning of engine sensor inputs may be performed at the fuel control and delivery subsystem 190, rather than by a separate subsystem.

The motor drive board 240 is designed to receive a variable low voltage input 242 from the motor drive controller board 250 and supply a variable high voltage output 244 to the motor 210 to drive the motor 210 at a desired speed. The motor drive board 240 further has means for providing monitoring signals 246 (e.g., motor voltage and motor current) to the motor drive controller board 250 (and subsequently through a communication link 248 to the motherboard 230 and ultimately to the diagnostic subsystem 160 via the engine management subsystem 110) for diagnostic purposes.

The motor drive controller board 250 of the disclosed embodiment is designed to receive a fuel flow signal proportional to a fuel flow rate and send a variable low voltage output 242 to the motor drive board 240 for variably controlling the speed of the motor 210. In one aspect of the invention, the fuel flow signal is provided by a flow meter 360 in the form of a flow meter signal which is proportional to the actual fuel flow rate through the fuel tube 220. The motor drive controller board 250 comprises a processing unit which can be pre-programmed to maintain the fuel flow rate at a particular value or to vary the fuel flow rate according to a predetermined fuel schedule. For example, such a preprogrammed motor drive controller board 250 may be used for unmanned aircraft applications (e.g., missiles). Alternatively, in addition to receiving a flow meter signal, the motor drive controller board 250 can receive a pump command 252 from the CPU board 260 (via the mother board 230) representing a desired fuel flow rate. In this embodiment, the motor drive controller board 250 would compare the pump command 252 to the flow meter signal to arrive at an error signal proportional to the desired change in fuel flow rate. The motor drive controller board 250 would then vary the_low voltage output 242 to the motor drive board 240 proportional to the error signal to vary the motor speed and consequently the fuel flow rate. Thus, in the above-described embodiments, the flow meter signal is used as a feedback mechanism for controlling the fuel flow rate in accordance with a preprogrammed fuel schedule or by comparing the flow meter signal to a pump command 252 received from the CPU board 260.

As a further input to the motor drive controller board 250, the fuel delivery subsystem 190 may comprise a position sensor 254 for sensing the position of the motor 210 and generating a tachometer signal 256 proportional to the fuel pump speed. The position sensor 254 (e.g., hall effects devices) is mounted adjacent the pump motor 210 for sensing magnetic poles in the motor 210 and generating an output in the form of a tachometer signal 256. The position sensor 254 can also be used to generate a position signal to be used for commutation sensing for proper timing of the drive signals.

Since the fuel pump 200 is a positive displacement pump, the speed of the pump 200 is approximately proportional to the amount of fuel passing through the pump 200. Accordingly, in one embodiment of the invention, the tachometer signal 256 can be used instead of a flow meter signal 361 as an approximation to the fuel flow rate under certain operating conditions. For example, flow meters positioned downstream of the fuel pump 200 may exhibit finite time delays before reflecting changes in the fuel flow rate caused by changes in the pump speed. That is, due to the distance from the pump 200 to the flow meter 360 and the energy needed to overcome rotational inertia to accelerate or decelerate the flow meter 360, there may be a time delay between a change in pump speed (accompanied by a change in fuel flow rate) and a change in the flow meter signal 3258. As such, the flow meter 360 may be relatively inaccurate at measuring actual fuel flow rate when there is a changing pump speed (i.e., when the pump speed is changing by a certain amount). In this regard, it may be beneficial to utilize the tachometer signal 256 as the feedback mechanism when the pump speed is being changed.

On the other hand, under steady state conditions (i.e., small changes in the fuel flow rate), the flow meter 360 is generally considered more accurate at reflecting actual fuel flow rate. This is due to the fact that, given a constant pump speed (i.e., constant tachometer signal 256), the actual fuel flow rate can change with a change in pump inlet pressure. The flow meter 360 can generally reflect this change in flow rate, while the tachometer signal 256 cannot. Accordingly, preferably the flow meter signal 258 will be used as the feedback mechanism when the error signal (i.e., the difference between the pump command 252 and the flow meter signal 258) is below a predetermined value and the tachometer signal 256 will be used as the feedback mechanism when the error signal exceeds the predetermined value. The quantity of such predetermined value is application specific. That is, it would depend on the type of engine, fuel, aircraft, etc., and would further depend on the damping and response characteristics desired in the servo loop.

The power/EMI board 280 performs three distinct functions for the fuel delivery subsystem 190. First, the board 280 receives power from an external source (e.g., a power generator or battery) through a communication port 282 (e.g., an RS-422 input or other appropriate port) and conditions the power into the unit sources of power. Second, the board 280 acts as an input and output corridor for passing signals to and from other subsystems in the IEC system 100 (e.g., via the engine management subsystem 110) through the communication port 282. Finally, the board 280 acts as an electromagnetic interference (EMI) filtering board to filter and isolate the power signal from the low voltage control and sensor signals.

The mother board 230 is a two-way feed-through path for the incoming signals to get to their appropriate board and outgoing signals to exit the subsystem. The mother board 230 further provides a structural surface to which the other boards in the system may be easily attached and detached for easy replacement.

As noted above, an analog interface board 270 may be utilized in the fuel control and delivery subsystem 190 if a separate engine sensor interface subsystem 150 is not used for conditioning engine sensor signals entering the engine management subsystem 110. The analog interface board 270 utilizes conventional linear and digital circuitry for signal conditioning of engine sensors to be used for engine control. The board 270 can receive external sensor inputs via a communication port 272 and pass them to the mother board 230 via communication link 278 after conditioning. Air inlet pressure is sensed by a pressure sensor 273 mounted within the housing 294 and a corresponding signal can be sent directly to the analog interface board 270 via a communication link 275. Such sensor inputs may include engine speed, engine inlet temperature, inlet pressure, exhaust gas temperature, or any other desired sensor input for a particular application. The analog interface board 270 is reconfigurable so it can condition whatever sensory information is desired for any particular application. The board is also capable of conditioning input signals 274 received through the mother board 230 (e.g. from the power/EMI board 280). Such information can be fed through the mother board 230 to the analog interface board 270 for conditioning, and then can be fed back to the mother board 230 as an output signal 276 to gain access to the CPU board 260 for processing.

The CPU board 260 is a reprogrammable and expandable processing unit capable of performing a variety of functions. For testing and diagnostics, the CPU board 260 can monitor engine parameters such as engine inlet pressure, engine inlet temperature, fuel temperature, ambient pressure, engine speed, fuel flow rate, exhaust gas temperature, or any other desired parameter. Such parameters can be monitored and/or sent directly to the engine and accessory diagnostic subsystem 160 through the engine management subsystem 110 (see Fig. 4). The CPU board 260 also provides the processing capabilities for calculating the pump command 252 corresponding to a desired fuel flow rate. Such pump command 252 is calculated based on the values of input parameters (e.g., thrust command from the aircraft, engine inlet pressure, ambient pressure, engine inlet temperature, engine speed, exhaust gas temperature, etc.) and the known relationships therebetween for the particular engine, fuel and aircraft. The pump command 252 is subsequently passed through the mother board 230 and to the motor drive controller for controlling the fuel pump speed (i.e., the fuel flow rate) as described above.

The CPU board 260 can also be programmed to control the temperature of the control electronics. As noted above, fuel is supplied to an electronics cold plate 330 to cool the control electronics during engine operation. However, overheating problems can also occur during engine shutdown, where soakback temperatures can easily exceed normal operating temperatures. The use of an electric fuel pump enables the CPU board 260 to be programmed to monitor the temperature of the control electronics (e.g., through temperature sensors) and continue circulation of the fuel during engine shutdown to insure that soakback temperatures do not exceed the electronics ratings. It can be appreciated that a gear-driven fuel pump cannot be utilized to pump fuel at a desired rate during engine shutdown and, therefore, engines utilizing gear-driven pumps face considerable obstacles in placing the control electronics in a high-temperature area on the engine, such as the jet core housing.

The CPU board 260 has a proprietary bussing scheme on it whereby memory is allocated into a memory map to be processed by the processing unit. The CPU board 260 includes some scratch pad memory such as RAM for making decisions on demand. There is also the capability for having a watchdog timer for taking care of any unnecessary interrupts that may have been caused by a disturbance in the process. There is also the capability to reprogram the program ROM 262 utilizing an electrically erasable memory. The boot ROM 264 is an ultraviolet erasable memory. Reprogramming of the CPU board 260 can be accomplished by downloading a new program from either the aircraft or ground personnel through the communication port 282. Reprogramming can be done to obtain appropriate responses for different applications (e.g., different engines, aircraft, fuel, etc.).

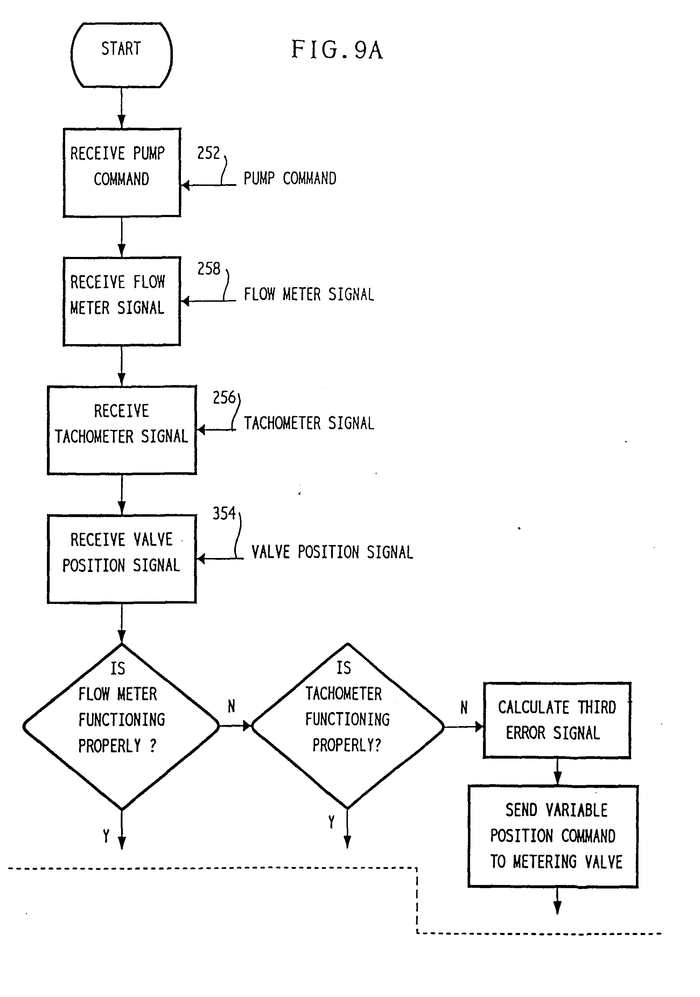

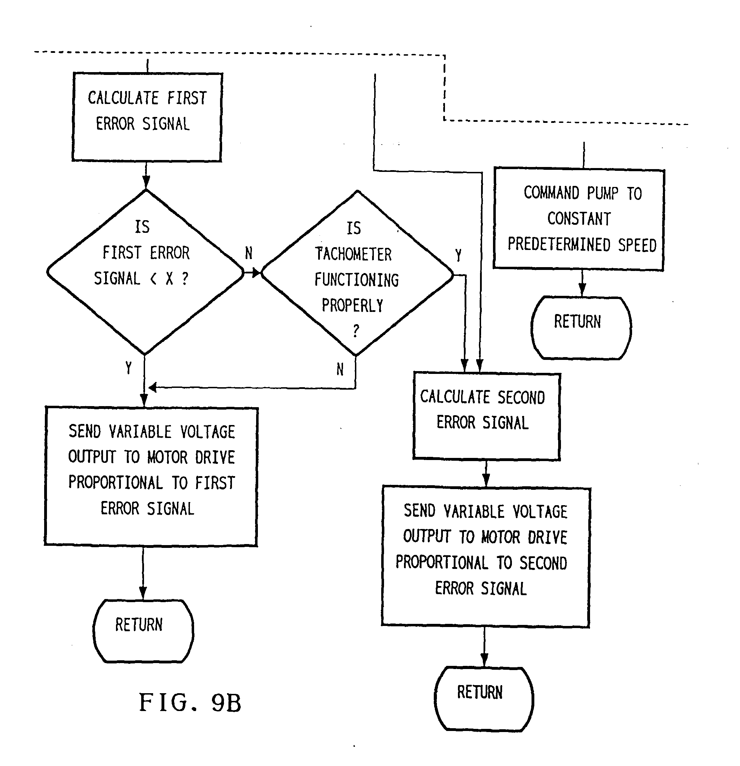

The method by which the motor drive controller board 250 controls the fuel flow rate is represented in the flow diagram of Fig. 9. In this regard, in one embodiment of the invention, the motor drive controller board 250 is capable of controlling the fuel flow rate in three different modes, thus providing a triple redundant fuel control system. In the first mode, the motor drive controller board varies the voltage supplied to the motor drive board 240 (and consequently varies the speed of the motor 210) utilizing feedback from the flow meter 360. In the second mode, the motor drive controller board 250 controls the voltage to the motor drive board 240 utilizing feedback from the tachometer (i.e., position sensor 254). Finally, in the third mode of operation, the motor drive controller board 250 controls the position of the backup metering valve 350 utilizing feedback from the position transducer (not shown) while maintaining the pump 200 at a constant predetermined speed.

As shown in the flow diagram of Fig. 9, the motor drive controller board 250 receives a pump command 252 (e.g., from the CPU board 260), a flow meter signal 258 (e.g., from the flow meter 360), a tachometer signal 256 (e.g., from the position sensor 254), and a valve position signal 354 (e.g., from the backup metering valve 350). The first step in determining the desired mode of operation is to determine whether the flow meter 360 is functioning properly. Such a determination can be made by the CPU board 260, for example, by examining the discrepancy between the tachometer signal 256 and the flow meter signal 258 or the discrepancy between the flow meter signal 258 and engine parameters (e.g., engine speed) and the known or predicted relationships therebetween. It should be appreciated that the determination of whether the flow meter 360 is functioning properly could also be performed using a built-in test on the flow meter or any other appropriate means.

If it is determined that the flow meter 360 is functioning properly, the motor drive controller board 250 will calculate a first error signal proportional to the difference between the pump command 252 and the flow meter signal 258. Next, the motor drive controller board 250 determines whether the first error signal is less than a predetermined value (i.e., whether the absolute value of the first error signal is below a predetermined value). The purpose of this step is to determine whether there is a large rate of change of the fuel flow rate and, accordingly, whether the tachometer signal 256 should be used as the feedback mechanism. If the first error signal is less than the predetermined value, then the motor drive controller board 250 will send a variable voltage output 242 to the motor drive board 240 proportional to the first error signal (i.e., utilizing the flow meter signal 258 as the feedback mechanism). Such variable voltage output 242 will be calculated by the motor drive controller board 250 based on a fuel control program for the particular engine, fuel and aircraft being used.

If, on the other hand, the first error signal is greater than the predetermined value, then the motor drive controller board 250 will want to utilize the tachometer signal 256 as the feedback mechanism as long as the tachometer signal 256 is not defective. Accordingly, the motor drive controller board 250 next determines whether the tachometer is functioning properly. This determination can be performed by the CPU board 260 (e.g., as indicated by the discrepancy between the tachometer signal 256 and the flow meter signal 258 or by comparing the tachometer signal 256 to other signals, such as the engine speed, and the predicted relationships therebetween). If it is determined that the tachometer signal 256 is not functioning properly, the motor drive controller board 250 will revert back and send a variable voltage output to the motor drive board 240 proportional to the first error signal, as described above. Even though the flow meter signal 258 can be inaccurate when the first error signal is greater than the predetermined value, it is better to utilize the flow meter signal 258 as the feedback mechanism rather than a tachometer signal 256 which may be defective. If the tachometer signal 256 is functioning properly, the motor drive controller board 250 will calculate a second error signal proportional to the difference between the pump command 252 and the tachometer signal 256. The motor drive controller board 250 will then send a variable voltage output to the motor drive board 240 proportional to the second error signal for controlling the speed of the fuel pump 200 (i.e., utilizing the tachometer signal 256 as the feedback mechanism). Again, such a variable voltage output 242 will be calculated by the motor drive controller board 250 based on a fuel control program for the particular engine, fuel and aircraft being used.

If it is determined that the flow meter 360 is not functioning properly, then the motor drive controller board 250 will need to determine if the tachometer is functioning properly, as noted above. If the tachometer is functioning properly, then the motor drive controller board 250 will control the fuel flow rate utilizing the tachometer signal 256 as the feedback mechanism, as described above. If, however, the tachometer is not functioning properly (i.e., in addition to the flow meter 360 not functioning properly), the motor drive controller board 250 will calculate a third error signal proportional to the difference between the pump command 252 and the valve tachometer signal 354. The motor drive controller board 250 will subsequently send a variable position command 356 to the metering valve 350 to move the metering valve 350 to the desired position corresponding to the desired fuel flow rate, as calculated based on known parameters. Once the metering valve 350 is in position, the motor drive controller board 250 commands the pump 200 to a constant predetermined speed. Such speed will be maintained and the fuel flow rate will subsequently be controlled by controlling the position of the metering valve 350.

It can be appreciated that the above-described process for controlling the fuel flow rate provides a triple-redundant fuel control system. That is, when the flow meter 360 is functioning properly and the difference between the flow meter signal 258 and the pump command 252 is below a predetermined value, the fuel flow rate will be controlled utilizing the flow meter signal 258 as the feedback mechanism. If it is determined that the flow meter 360 is not functioning properly and/or the first error signal is greater than the predetermined value, the tachometer signal 256 will be used by the motor drive controller board 250 as the feedback mechanism. If both the flow meter 360 and the tachometer are determined to be functioning improperly, the motor drive controller board 250 will command the pump 200 to a constant speed and control the fuel flow rate by controlling the position of the metering valve 350, based on known relationships between such valve position and the fuel flow rate.

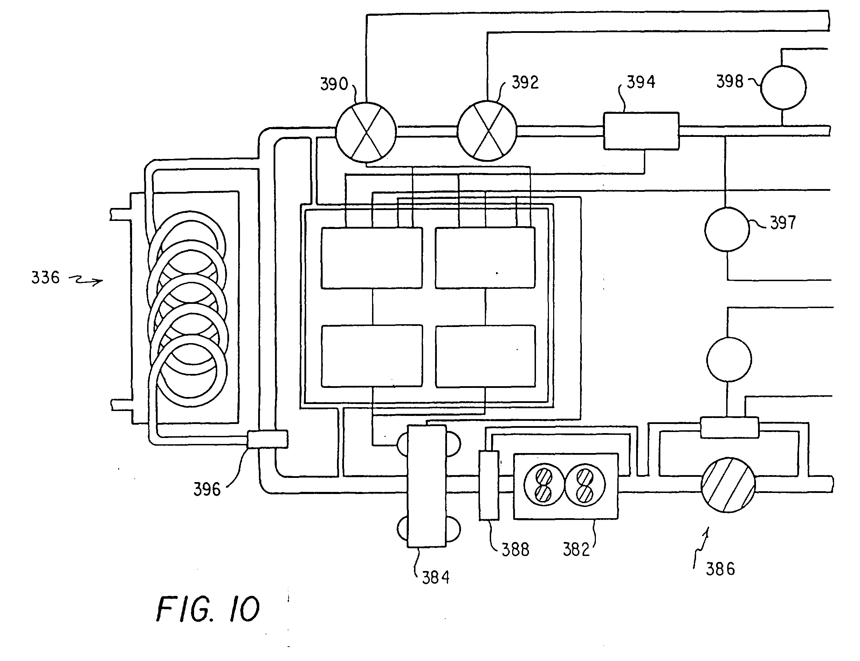

The oil control and delivery subsystem 380 is an adaptive oil system which can modify the oil flow rate under changing operating conditions as reflected by sensor signals. As shown in Fig. 10, the oil control and delivery subsystem 380 includes an oil pump 382, a motor 384 and control electronics in a similar configuration to the fuel control and delivery subsystem 190, but appropriately designed for oil supply rather than fuel supply. Similarly, as further shown in Fig. 11, the oil control and delivery subsystem 380 may further comprise an oil filter and bypass assembly 386, a pressure relief valve 388, a primary fuel shutoff and backup metering valve 390, a secondary fuel shutoff 392, a flow meter 394, a pressure sensor 397 and a temperature sensor 398 to provide operations similar to that of the fuel control and delivery subsystem 190. In addition, the oil control and delivery subsystem 380 may comprise an oil cooling valve 396 for regulating the amount of oil entering the oil cooler 336.

Similar to the fuel control and delivery subsystem 190, the oil control and delivery subsystem 380 is designed to be a triple-redundant oil control system. That is, the feedback mechanism for controlling the oil flow rate can comprise the flow meter signal from the flow meter 394, the tachometer signal from the position sensor, or the valve position signal from the backup metering valve 390. Similar to the fuel subsystem 190, the determination of which of the three feedback mechanisms to utilize for the oil subsystem 380 can be performed by the method represented in the flow diagram of Fig. 9.

The determination of the appropriate oil flow rate can be dependant on any number of desired variables. For example, it is generally known that fluid pumps become less efficient through use due to pump wear. As such, it may be desirable to program the oil control and delivery subsystem 380 to compensate for such pump wear by gradually increasing the pump speed over time. Such pump wear may also be detectable by monitoring the oil pressure and may further be compensated for by altering the pump speed. For example, the pump speed could be increased to compensate for a drop in oil pressure and could be decreased in response to an increase in oil pressure.

In addition, it may be desirable to monitor the oil temperature and correspondingly control the oil flow rate to maintain the oil within a desired temperature range. For example, the oil flow rate could be increased to compensate for an increase in oil temperature and, correspondingly, decreased in response to a decrease in oil temperature. Similarly, it may be desirable to monitor the engine temperature, especially at the compressor and turbine bearings (e.g., at the gear box and/or powerhead) where the oil is used for lubrication and cooling, to maintain the bearing temperature within a desired temperate range (e.g., increase oil flow rate if bearing temperature increases, and vice versa).

The temperature of the oil can also be controlled by monitoring and controlling the position of the oil cooling valve 396. That is, the position of the oil cooling valve 396 can be altered to regulate the amount of oil diverted to the fuel-cooled oil cooler 336, thus regulating the temperature of the oil. For example, more oil could be diverted to the cooler if the oil temperature increases and less oil could be diverted if the oil temperature decreases. Of course, such an oil cooling valve could divert oil to any appropriate oil cooling device (e.g., and air-cooled or coolant-cooled oil cooler).

It should be appreciated that the prior art mechanically-driven oil pumps do not achieve the beneficial results of the present invention. More specifically, the prior art oil supply systems cannot vary the oil flow rate independently of the speed of the turbine. As such, the prior art oil supply systems cannot compensate for pump wear, cannot compensate for oil temperature changes, and cannot compensate for turbine bearing temperature changes in a manner accomplishable by the present invention.

It should be appreciated that, if an electric oil pump and an electric fuel pump are used in the same system, the respective control means (e.g., the CPU boards and motor controller boards) could be replaced by a single control board, such as a multi-function microprocessor. Such microprocessor could also perform the function of other subsystem within the IEC system, such as diagnostics, aircraft communication, ground communication, etc.

As noted above, all of the subsystems of the IEC system are preferably collocated in one area of the aircraft. In this regard, it is further desirable to position the entire IEC system in a single IEC box 400 (shown in Fig. 2). The box 400 is preferably detachably connected to the aircraft (e.g., the jet core housing 66) such that the entire IEC system 100 can be replaced quickly and easily. Such a box would should be designed to meet several important design criteria. First, it should act as an electro-magnetic interference barrier to isolate the low-level sensor and communication signal from transient magnetic fields in the aircraft. Also, the box should provide an adequate thermal barrier from engine operating and soak-back temperatures. Furthermore, the box must be structurally adequate to survive shocks and vibrations associated with gas turbine engines. Preferably, a composite wall structure comprising metal-impregnated composite material and honeycomb material is used for such an application. It is believed that a wall structure of aluminum extrusion would also satisfy the above considerations in some applications.

In addition to the above-noted benefits of the present invention, the utilization of electrically-driven fluid pumps (i.e., for fuel and oil) further provides the benefit of being able to preheat the fluid before start-up of the engine. More specifically, in another aspect of the invention, a method is disclosed whereby the electric motors (i.e., the fuel and oil motors) which drive the fluid pumps can be sent an illegal commutation command from the motor drive controller board (or any appropriate board, such as the CPU board). Sending an illegal commutation command results in stalling of the motor, which generates heat in the motor without rotation of the motor. Such heat can then be dissipated to the fluid within the electric motor (e.g., due to the heat sink relationship between the motor stator 214 and the fluid through the housing 204) to heat the fluid therein. After the fluid within the motor has been heated, the pump can be sent a legal commutation command to rotate the motor and pump a small amount (e.g., about one revolution) to discharge the heated fluid and intake a fresh charge of unheated fluid. The steps of sending an illegal command, dissipating heat, and sending a legal command are performed sequentially such that the motor alternately operates in a stalled condition (i.e., by sending an illegal commutation command) and a rotating condition (i.e., by sending a legal commutation command) to sequentially heat a substantial portion of the fluid in the engine. Such a method for heating the fluid in a gas turbine engine is especially beneficial for starting an engine under cold conditions. For example, for starting an auxiliary power unit at high altitude or for starting a standard thrust engine under arctic conditions.

In yet another aspect of the invention, the IEC system 100 is collocated in one serviceable location on the aircraft, as briefly noted above. For example, all of the subsystems could be positioned on the side of the jet core housing 66 adjacent a service hatch (not shown), thus providing easy accessibility to the system. This would allow the entire IEC system to be serviced by one individual at a single location on the engine 20. The IEC is designed such that the entire IEC can be replaced by a service technician is approximately twenty-two (22) minutes. This compares to approximately three to four (3-4) hours needed to replace a prior art, mechanically-driven fuel pump. As such, the present invention provides for much quicker serviceability, resulting in shorter flight delays and decreased costs. It should be appreciated that the IEC system could also be positioned at other locations on the aircraft (e.g., in the nacelle, the pylon assembly, or the wing) and still achieve many of the benefits of the present invention.

The collocation of all of the subsystems in one serviceable location also provides for easier replacement of the jet core 62. More specifically, when replacing the jet core 62, it is also necessary to replace the fuel pump 70 because the jet core 62 (more specifically, the turbine section 50) and fuel pump 70 are certified together in a matched set. As such, in the prior art engine, because the fuel pump 70 is mounted to the fan housing 32, it is necessary to replace the fan section 30 (including the radial struts 34, fan blades 38 and fan housing 32) when replacing the jet core 62. Because a fan housing 32 can be as large as ten feet in diameter, replacement of a prior art jet core 62 can be a complicated and costly process. In contrast, because the fuel pump 200 of the present invention is mounted directly on the jet core housing 66, the jet core 62 can be replaced without the need to remove the fan section 30. Accordingly, replacement costs associated therewith are significantly reduced.

Furthermore, the repositioning of the fuel and oil pumps from the lower portion of the nacelle to the jet core housing allows for a more aerodynamic gas turbine engine. More specifically, the nacelle of the engine creates as much as 10% of the aerodynamic drag of the engine. Because the gear boxes and drive shafts have been eliminated and the fluid pumps have been downsized and moved out of the nacelle, the profile of the lower portion of the nacelle can be made significantly smaller, as shown in Fig. 2 (i.e., compared to Fig. 1). Such a decrease in nacelle size should provide for about a 2% decrease in specific fuel consumption (i.e., amount of fuel used per unit power delivered).

It should be appreciated that the nacelle 28 could still be reduced in size even if the IEC system 100 is located in the nacelle 28. This is because of the substantial decrease in pump size associated with providing an on-demand pump system (i.e., versus a gear-driven system requiring excessively large pumps to meet start flow requirements), and further because of the elimination of pump gear boxes.

It can further be appreciated that the elimination of drive shafts, gear boxes, and over-sized pumps provides a considerable weight benefit to the aircraft. It has been observed that utilization of an IEC system embodying the present invention in certain missile applications has reduced the fluid control subsystem weight from about 13 pounds to about 4.2 pounds. It is believed that a CFM56-5B engine could save as much as about 50 pounds, or more, by changing from a gear driven pump and metering valve arrangement to the IEC system of the present invention.

The foregoing description of the present invention has been presented for purposes of illustration and description. Furthermore, the description is not intended to limit the invention to the form disclosed herein. Consequently, variations and modifications commensurate with the above teachings, and the skill or knowledge of the relevant art, are within the scope of the present invention. The embodiments described hereinabove are further intended to explain best modes known for practicing the invention and to enable others skilled in the art to utilize the invention in such, or other, embodiments and with various modifications required by the particular applications or uses of the present invention. It is intended that the appended claims be construed to include alternative embodiments to the extent permitted by the prior art.

## Claims

1. A method for heating a fluid in an engine having a fluid pump driven by an electric motor, said method comprising the steps of:
sending an illegal commutation command to the electric motor to stall the motor, thereby generating heat; and
dissipating the heat to at least a portion of the fluid.

2. A method, as claimed in Claim 1, wherein said step of dissipating heat in accomplished by positioning the motor in heat sink relationship with the fluid.

3. A method, as claimed in Claim 1, further comprising:
sending a legal commutation command to the electric motor to rotate the motor and fluid pump to pump at least a portion of the fluid.

4. A method, as claimed in Claim 1, wherein said steps of sending an illegal command, dissipating heat, and sending a legal command are performed sequentially to heat the fluid in the engine.

5. A method, as claimed in Claim 1, wherein the fluid is fuel.

6. A method, as claimed in Claim 1, wherein the fluid is oil.

7. An engine oil pumping device for a gas turbine engine, said device comprising:
an oil pump for pumping oil through an oil line to a gas turbine engine;
drive means for driving said oil pump; and
control means for sending a variable output to said drive means for variably controlling the speed of said drive means.

8. An engine oil pumping device, as claimed in Claim 7, further comprising:
feedback means for providing a feedback signal relating to an oil flow rate through said oil line.

9. An engine oil pumping device, as claimed in Claim 8, wherein said feedback means is selected from the group consisting of: a flow meter and a tachometer.

10. An engine oil pumping device, as claimed in Claim 8, wherein said feedback means comprises:
a flow meter for measuring fuel flow rate and generating a flow meter signal proportional to the fuel flow rate; and
a tachometer sensor for measuring an oil pump speed and generating a tachometer signal proportional to the speed, wherein said control means receives said tachometer signal, and wherein said variable output is dependent on said flow meter signal under a first predetermined set of conditions, and wherein said variable output is dependent on said tachometer signal under a second predetermined set of conditions.

11. An engine oil pumping device, as claimed in Claim 10, further comprising:
a metering valve operatively connected to said control means and positioned adjacent said oil line for selectably controlling the oil flow rate through said oil line; and
a valve position sensor, operatively connected to said control means, for sensing the position of said metering valve and generating a valve position signal proportional to the position of said metering valve, wherein said variable output is sent to said metering valve to control the position thereof and is dependent on said valve position signal under a third predetermined set of conditions.

12. An engine oil pumping device, as claimed in Claim 7, further comprising:
an engine sensor input means for receiving an engine signal corresponding to an engine parameter, wherein said control means receives said engine signal, and wherein said variable output is dependent on said engine signal.

13. An engine oil pumping device, as claimed in Claim 12, wherein said engine parameter is selected from a group consisting of: oil temperature, oil pressure, engine bearing temperature, and exhaust gas temperature.

14. An engine oil pumping device, as claimed in Claim 7, wherein said control means increases the speed of said drive means under a first predetermined set of conditions.

15. An engine oil pumping device, as claimed in Claim 14, wherein said first predetermined set of conditions is selected from the group consisting of: increased pump wear, increased oil temperature, increased bearing temperature, increased exhaust gas temperature, and decreased oil pressure.

16. An engine oil pumping device, as claimed in Claim 7, wherein said control means decreases the speed of said drive means under a second predetermined set of conditions.

17. An engine oil pumping device, as claimed in Claim 16, wherein said second predetermined set of conditions is selected from the group consisting of: decreased oil temperature, decreased bearing temperature, decreased exhaust gas temperature, and increased oil pressure.

18. , An engine oil pumping device, as claimed in Claim 7, further comprising:
an oil cooling means, connected in parallel to said oil line, for cooling at least a portion of the oil; and
an oil cooling valve operatively connected to said control means and positioned at a junction of said oil cooling means and said oil line, wherein said cooling valve in controllable by said control means to selectively control the amount of oil which is diverted to said cooling means.

19. An engine oil pumping device, as claimed in Claim 7, further comprising:
output means for providing monitoring signals corresponding to an operating parameter to an external source.

20. An engine oil pumping device, as claimed in Claim 19, wherein said operating parameter is selected from a group consisting of: drive means current, oil pump speed, oil flow rate, oil temperature, and oil pressure.

21. An engine oil pumping device, as claimed in Claim 7, wherein said control means comprises a microprocessor.

22. An engine oil pumping device, as claimed in Claim 7, wherein said drive means is an electric motor and wherein said variable output comprises a variable voltage.

23. An engine oil pumping device, as claimed in Claim 22, wherein said drive means is a brushless electric motor having a tubular rotor.

24. An engine control system for monitoring and controlling the operation of a gas turbine engine, comprising:
a variable speed electric fuel pump capable of supplying fuel to the engine;
a variable speed electric oil pump capable of supplying oil to the engine; and
control means, operatively connected to said fuel pump and said oil pump, for generating a fuel control voltage for controlling a speed of said fuel pump and an oil control voltage for controlling a speed of said oil pump.

25. An engine control system, as claimed in Claim 24, wherein said control means comprises:
input means for receiving input signals, wherein said fuel control voltage and said oil control voltage are dependent on said input signal.

26. An engine control system, as claimed in Claim 25, wherein said control means is capable of receiving input signals which correspond to engine parameters selected from a group consisting of: engine inlet pressure, engine inlet temperature, engine speed, ambient pressure, exhaust gas temperature, fuel temperature, fuel pressure, oil temperature, and oil pressure.

27. An engine control system, as claimed in Claim 24, wherein said control means further comprises:
output means for providing monitoring signals corresponding to a control system parameter.

28. An engine control system, as claimed in Claim 27, wherein said control system parameter is selected from a group consisting of: fuel pump current, oil pump current, fuel pump speed, oil pump speed, fuel flow rate, oil flow rate.

29. An engine control system, as claimed in Claim 24, wherein said control means comprises at least one microprocessor.

30. An engine control system, as claimed in Claim 24, wherein said electric fuel pump includes a brushless electric motor having a tubular rotor.

31. An engine control system, as claimed in Claim 24, wherein said electric oil pump includes a brushless electric motor having a tubular rotor.

32. A gas turbine engine having an electric engine control system for monitoring and controlling the operation of the engine, comprising:
a gas turbine engine;
a variable speed electric fuel pump capable of supplying fuel to said engine;
a variable speed electric oil pump capable of supplying oil to said engine; and
control means, operatively connected to said fuel pump and said oil pump, for generating a fuel control voltage for controlling a speed of said fuel pump and an oil control voltage for controlling a speed of said oil pump.

33. A gas turbine engine, as claimed in Claim 32, wherein each of said fuel pump, said oil pump, and said control means are collocated in one area of said engine.

34. A gas turbine engine, as claimed in Claim 33, wherein each of said fuel pump, said oil pump, and said control means are collocated on the jet core housing of said engine.
